# FASCICULE DE BREVET EUROPEEN

(11) **EP 1 410 405 B1**
(45) Date de publication et mention de la délivrance du brevet: **18.10.2006**
(21) Numéro de dépôt: 02790199.0
(22) Date de dépôt: 18.07.2002
(51) Int. Cl.: H01B 13/16, H01F 41/12, H01L 39/24

(54) **PROCEDE DE FABRICATION D'UNE GAINE ELECTRIQUEMENT ISOLANTE ET MECANIQUEMENT STRUCTURANTE SUR UN CONDUCTEUR ELECTRIQUE**
VERFAHREN ZUR HERSTELLUNG EINER ELEKTRISCH ISOLIERENDEN UND MECHANISCH STRUKTURIERENDEN MANTELUNG AUF EINEM ELEKTRISCHEN LEITER
METHOD FOR MAKING AN ELECTRICALLY INSULATING AND MECHANICALLY STRUCTURING SHEATH ON AN ELECTRICAL CONDUCTOR

(30) Priorité: 20.07.2001 FR 0109741
(43) Date de publication de la demande: 21.04.2004
(73) Titulaire: COMMISSARIAT A L'ENERGIE ATOMIQUE, 75752 Paris 15ème (FR)
(72) Inventeur: REY, Jean-Michel, F-92330 Sceaux (FR); MARCHANT, Sandrine, F-94340 Joinville Le Pont (FR); DEVRED, Arnaud, F-75006 Paris (FR); PROUZET, Eric, F-34000 Montpellier (FR)
(74) Mandataire: Poulin, Gérard
(86) Numéro de dépôt international: PCT/FR2002/002562
(87) Numéro de publication internationale: WO 2003/010781

(56) Documents cités:
- EP-A- 0 044 144
- EP-A- 0 188 370
- EP-A- 0 435 154
- US-A- 5 021 401
- ANANTHAKUMAR S ET AL: "Effect of nanoparticulate boehmite sol as a dispersant for slurry compaction of alumina ceramics" MATERIALS LETTERS, vol. 43, no. 4, avril 2000 (2000-04), pages 174-179, XP004195149 ISSN: 0167-577X cité dans la demande

## Description

### Domaine technique

La présente invention concerne un procédé de fabrication d'une gaine électriquement isolante et mécaniquement structurante sur un conducteur électrique.

Elle s'applique notamment à la fabrication d'aimants supraconducteurs ainsi qu'à la fabrication de pièces polaires d'un moteur électrique.

La nécessité de disposer d'une isolation électrique structurante, obtenue à partir d'un précurseur céramique flexible, est commune à de nombreuses applications électrotechniques.

Le précurseur se présente, selon une variante de l'invention, sous la forme d'un tissu imprégné souple, permettant la mise en forme du conducteur que l'on veut isoler et, dans certains cas, assure le contrôle de l'épaisseur et détermine la précision géométrique de bobinages réalisés au moyen du conducteur.

A l'issue d'un traitement thermique à une température de l'ordre de 700°C, le précurseur est fritté et l'isolation électrique ainsi constituée absorbe les efforts mécaniques exercés sur le conducteur lors de phases ultérieures d'assemblage et de fonctionnement. La nature céramique de l'isolation réalisée autorise des températures de fonctionnement allant de 1,8 K à 1270 K.

Ces propriétés sont capitales lors de la réalisation d'aimants supraconducteurs, capables d'engendrer d'intenses champs magnétiques pour lesquels on se heurte à une difficulté majeure.

En effet, les matériaux ayant des propriétés supraconductrices et la capacité de faire circuler des densités de courant élevées, matériaux parmi lesquels on trouve le composé intermétallique défini Nb₃Sn ou encore Nb₃Al, requièrent un traitement thermique à une température élevée (supérieure à 600°C pour Nb₃Sn et à 700°C pour Nb₃Al), de longue durée (supérieure à 100 heures pour Nb₃Sn et de l'ordre de quelques dizaines d'heures pour Nb₃Al) et en présence d'une atmosphère inerte ou sous vide.

Les conditions de température mentionnées ci-dessus interdisent l'utilisation des isolations électriques classiques, réalisées à partir de produits organiques, pendant le traitement thermique. De plus, le matériau supraconducteur obtenu à l'issue de ce traitement thermique est fragile et les éventuelles contraintes mécaniques qui sont susceptibles de lui être appliquées peuvent aisément détériorer ses propriétés supraconductrices.

Il n'est donc plus possible, après le traitement thermique, d'assurer la mise en forme de ce matériau ni les cintrages requis pour son bobinage. Dans ces conditions, la mise en place de l'isolation électrique est particulièrement délicate.

La solution classique pour remédier aux inconvénients précédents consiste à :
- enrubanner un câble supraconducteur, avant son bobinage, à l'aide d'un ruban de fibres minérales supportant le traitement thermique,
- effectuer ce traitement thermique, puis
- placer le bobinage dans un moule d'imprégnation sous vide, et
- effectuer une imprégnation de résine organique.

Les opérations de transfert du bobinage sont particulièrement délicates et n'ont, à ce jour, jamais permis la production en série de bobinages complexes (du type dipolaire ou quadripolaire), de grande taille (notamment de longueur supérieure à 1 mètre), utilisant des supraconducteurs de la famille du Nb₃Sn.

Le coût des matériaux supraconducteurs utilisés (de l'ordre de 750 €/kg à 2000 €/kg suivant les procédés de réalisation utilisés) ainsi que le temps de traitement et la durée des opérations de bobinage représentent plus de 30% du coût de fabrication des électro-aimants supraconducteurs.

Le risque associé au transfert du moule de réaction (dans lequel le précurseur de supraconducteur est transformé en supraconducteur) vers le moule d'imprégnation est donc très important.

La possibilité de disposer d'un bobinage complètement isolé et présentant une intégrité mécanique complète à l'issue du traitement de réaction du supraconducteur permettrait de développer l'industrialisation des électro-aimants supraconducteurs.

### Etat de la technique antérieure

On connaît déjà des techniques d'isolation électrique d'électro-aimants supraconducteurs en Nb₃Sn. Mais toutes ces techniques connues nécessitent une imprégnation à l'aide d'une résine époxy et ne permettent pas d'assurer la tenue mécanique du bobinage d'un électro-aimant supraconducteur pour résister aux efforts magnétiques engendrés par le fonctionnement de l'électro-aimant pour des champs intenses.

D'autres techniques connues utilisent une isolation céramique.

On se reportera en particulier au document suivant :
EP-A-0044144 (invention de G.R. Sutcliffe, S.J. Warden et D. Humpherson), correspondant à US-A-4,407,062.

Cependant, toutes ces autres techniques connues consistent à déposer un isolant autour de brins d'un matériau supraconducteur, soit par passage de ces brins dans une solution d'un précurseur inorganique, soit par extrusion du précurseur autour des brins au travers de dés, et aucune de ces autres techniques connues ne permet de disposer d'un ruban de fibres minérales, ce ruban étant pré-imprégné du précurseur d'une matrice céramique.

### Exposé de l'invention

La présente invention a pour but de remédier aux inconvénients des techniques connues de fabrication de gaines électriquement isolantes sur des conducteurs électriques, en particulier ceux qui sont faits de matériaux supraconducteurs.

L'invention a pour objet un procédé de fabrication d'un isolant électrique que l'on peut déposer sur un conducteur électrique ou avec lequel on peut enrubanner ce conducteur, en particulier dans le cas d'un conducteur destiné à être bobiné, le procédé permettant d'enrubanner le conducteur avec l'isolant ou de déposer ce dernier, avant le bobinage du conducteur.

Ce procédé vise aussi à laisser une certaine souplesse au conducteur ainsi revêtu, cette souplesse permettant de cintrer, en particulier de bobiner, ce conducteur.

De plus, ce procédé permet la synthèse d'un matériau céramique lors d'un traitement thermique.

Dans le cas particulier du bobinage, l'invention conduit aux résultats suivants, notamment dans le cas d'un conducteur supraconducteur :
- l'isolation électrique du conducteur est adéquate,
- la cohésion mécanique du bobinage à température ambiante est bonne,
- cette cohésion mécanique est maintenue lors d'un refroidissement par l'hélium liquide du conducteur isolé ainsi que lors de l'alimentation du bobinage en courant,
- la maîtrise des dimensions du bobinage est bonne, en particulier en ce qui concerne l'espacement entre les tours de bobinage, et ce, à toute température, et
- le bobinage présente avantageusement une certaine porosité à l'hélium liquide.

De plus, l'isolant céramique fabriqué conformément à l'invention est dépourvu de phase organique à l'issue du traitement thermique et ne requiert pas l'ajout d'une phase organique pour obtenir ses propriétés d'isolation électrique.

En outre, dans un mode de réalisation particulier, cet isolant est formé d'une matrice céramique renforcée de fibres céramiques courtes.

De façon précise, la présente invention a pour objet un procédé de fabrication d'une gaine électriquement isolante et mécaniquement structurante sur un conducteur électrique, en particulier un conducteur en métal non supraconducteur ou un conducteur en précurseur de supraconducteur, ce procédé comprenant les étapes de :
- formation d'un précurseur de céramique sous forme gélifiée,
- formation d'un revêtement du conducteur avec ce précurseur de céramique sous forme gélifiée et donc sans sédimentation, et
- traitement thermique de ce revêtement, ce traitement thermique étant apte à former la céramique à partir du précurseur de céramique sous forme gélifiée.

Un tel procédé est connu du EP 0 435 154.

Selon l'invention revendication 1, le précurseur de céramique est un liquide constitué par une solution comprenant de l'eau, un composant minéral, choisi parmi la boehmite et les argiles de la famille du kaolin, et un liant organique et l'on fait réagir le composant minéral avec un acide pour gélifier la solution et donc obtenir le précurseur de céramique sous forme gélifiée.

L'acide peut être choisi dans le groupe comprenant l'acide borique, l'acide citrique, l'acide chlorhydrique, l'acide nitrique et les acides carboxyliques, préférentiellement l'acide formique.

La solution peut comprendre en outre de la fritte de verre et/ou au moins un oxyde minéral supplémentaire.

Selon un mode de réalisation particulier de l'invention, la solution comprend, en pourcentage massique, 35% à 45% d'eau, 8% à 30% du composant minéral, 1% à 10% de liant organique, 0% à 15% d'un ou d'une pluralité d'oxydes minéraux supplémentaires et un complément éventuel de fritte de verre, ce complément éventuel de fritte de verre allant, bien entendu, de 0% à 56%.

Il est à noter que le rôle de l'eau dans cette solution est de rendre le mélange fluide et aussi d'hydrater les oxydes minéraux, notamment la boehmite ou le kaolin. Dans la suite du traitement, l'eau est évaporée au cours d'un séchage et, par conséquent, il serait tout à fait possible d'augmenter quelque peu artificiellement le pourcentage d'eau dans la solution et de diminuer, en proportion, celui des autres constituants, sans sortir du cadre de l'invention car il suffirait alors de prolonger la phase de séchage pour éliminer le surplus d'eau.

Evidemment, il ne faut pas rajouter tellement d'eau que la gélification serait dégradée.

Selon un mode de réalisation préféré de l'invention, le pourcentage massique du composant minéral va de 15% à 30% dans cette solution, le complément éventuel de fritte de verre allant alors, bien entendu, de 0% à 49%.

Chaque oxyde minéral supplémentaire peut être choisi dans le groupe comprenant l'alumine, la zircone, la silice et les argiles silico-alumineuses.

Selon l'invention (revendication 1), ce procédé comprend en outre une étape d'élimination du liant organique après l'étape de formation du revêtement, cette étape d'élimination commençant avant l'étape de traitement thermique apte à former la céramique mais se terminant pendant cette étape de traitement thermique, de sorte que ces deux étapes se recouvrent partiellement dans le temps.

De préférence, le procédé comprend en outre une étape d'élimination du liant organique par réaction avec l'oxygène, après l'étape de formation du revêtement.

Selon un premier mode de mise en oeuvre particulier du procédé objet de l'invention, le conducteur est en précurseur du supraconducteur Nb₃Sn ou Nb₃Al et l'on effectue un traitement thermique global de ce conducteur pourvu du revêtement, ce traitement thermique global étant effectué dans une atmosphère neutre et apte à former le supraconducteur Nb₃Sn ou Nb₃Al, éliminer le liant organique et former la céramique.

Selon un deuxième mode de mise en oeuvre particulier, le conducteur est en précurseur d'un supraconducteur à base d'oxyde de cuivre, en particulier YBa₂Cu₃O₇, Bi₂Sr₂CaCu₂O₂ ou Bi₂Sr₂Ca₂Cu₃O₁₀, et l'on élimine le liant organique par chauffage, dans l'air, du conducteur pourvu du revêtement puis on effectue un traitement thermique global, dans l'air, du conducteur pourvu du revêtement, ce traitement thermique global étant apte à former le supraconducteur à base d'oxyde de cuivre et à former la céramique.

Selon un troisième mode de réalisation particulier, le conducteur est en un métal non supraconducteur et l'on effectue un traitement thermique global de ce conducteur pourvu du revêtement, ce traitement thermique global étant effectué dans une atmosphère neutre et apte à éliminer le liant organique et à former la céramique.

L'étape de formation du revêtement peut comprendre une étape de dépôt du précurseur de céramique sous forme gélifiée sur un tissu de fibres céramiques préalablement désensimé (c'est-à-dire un tissu de fibres céramiques dont l'ensimage a été préalablement enlevé), puis une étape de disposition du tissu pourvu du précurseur de céramique autour du conducteur.

Les fibres de céramique peuvent être faites d'un matériau choisi parmi le verre E, le verre C, le verre R, le verre S2, la silice, l'alumine et la mullite.

Le tissu de fibres céramiques peut être préalablement désensimé de façon thermique ou chimique.

Selon un mode de réalisation particulier de l'invention, on met en forme, en particulier on bobine, le conducteur pourvu du revêtement, avant l'étape de traitement thermique apte à former la céramique.

### Brève description des dessins

La présente invention sera mieux comprise à la lecture de la description d'exemples de réalisation donnés ci-après, à titre purement indicatif et nullement limitatif, en faisant référence aux dessins annexés sur lesquels :
- la figure 1 illustre schématiquement un mode de mise en oeuvre particulier du procédé objet de l'invention et
- la figure 2 illustre schématiquement une application particulière de l'invention.

### Exposé détaillé de modes de réalisation particuliers

On donne maintenant des exemples du procédé de fabrication d'une gaine électriquement isolante et mécaniquement structurante sur un conducteur électrique conformément à l'invention. Ce conducteur est par exemple un fil ou un câble électrique.

Il convient de noter que le procédé s'applique aussi bien à des conducteurs ordinaires, en métaux non supraconducteurs, qu'à des supraconducteurs. De plus, ce procédé est compatible avec la technique appelée "WAR" (pour "Wind And React").

Dans un exemple de l'invention, on utilise un ruban de verre imprégné d'un précurseur de céramique. Ce précurseur de céramique est obtenu à partir d'une solution liquide et il est sans sédimentation car la solution liquide contient de la boehmite ou une argile de la famille du kaolin, que l'on a fait réagir avec un acide pour obtenir une gélification de cette solution liquide.

Cette propriété d'homogénéité du précurseur de céramique, permettant d'obtenir un isolant structurant, facilite son utilisation lors de son dépôt sur le conducteur, en particulier dans le cas où ce dépôt se fait par passage du conducteur dans un bain de ce précurseur de céramique, ce bain servant à former une gaine flexible qui autorise la mise en forme (en particulier le bobinage) ultérieure du conducteur.

Après cuisson du conducteur ainsi traité et mis en forme, la gaine est rigide et le conducteur (en particulier le supraconducteur) se trouve électriquement isolé et pris dans une matrice céramique. La résistance aux contraintes mécaniques est considérablement accrue par rapport à l'art antérieur. L'isolation électrique est très bonne et la porosité de la gaine est faible du fait de la vitrification.

On précise que l'invention s'applique en particulier à la fabrication d'électro-aimants à champs élevés et de bobinages pour moteurs électriques.

Donnons maintenant un exemple du procédé objet de l'invention.

Dans une première étape de ce procédé, on fabrique le précurseur de céramique sous la forme d'une solution liquide, plus ou moins visqueuse et sans sédimentation.

La composition de cette solution en pourcentage massique est :
- 35% à 40% d'eau,
- 1% à 10% d'un liant organique (commercialement disponible),
- 15% à 30% de boehmite ou d'une argile de la famille du kaolin,
- 0% à 15% d'autres oxydes minéraux tels que l'alumine, la zircone, la silice, une argile silico-alumineuse (par exemple le mica), qui forment un apport de charges minérales, et
- 5% à 49% de fritte de verre.

Après agitation de cette solution, par exemple au moyen d'un tourne-jarre lent ou d'un agitateur magnétique, on ajoute l'acide pour obtenir la gélification de la solution en présence de boehmite ou de l'argile de la famille du kaolin. On utilise par exemple l'acide formique avec un pourcentage massique de 0,3% à 2%. On élimine ainsi la sédimentation.

Le gel est formé par la réaction chimique de l'acide sur la boehmite ou l'argile de la famille du kaolin et le reste de la solution se trouve pris dans le gel. La gélification permet d'utiliser beaucoup moins de liant organique par rapport à la technique traditionnelle qui consiste à ajouter un dispersant organique qu'il faut ensuite éliminer.

Au sujet de la gélification en présence de boehmite mais dans un domaine technique totalement différent, on pourra se reporter au document suivant :
Article de F. Ananthakumar et al., Materials Letters 43, pages 174-179, 2000.

On utilise dans cet exemple de l'acide formique car la molécule de cet acide ne contient qu'un atome de carbone et donne des propriétés de gélification intéressantes mais d'autres acides peuvent être utilisés, par exemple l'acide nitrique, l'acide borique, l'acide chlorhydrique, l'acide citrique ou un autre acide de la famille des acides carboxyliques. De plus, l'acide formique est un acide relativement fort parmi les acides faibles, mais si l'on utilise un acide plus faible il en faudra davantage.

La viscosité de la solution est réglée selon les besoins, par dosage des diverses charges minérales et de l'eau.

En particulier, on peut ajouter des charges fibreuses pour obtenir un précurseur de céramique visqueux voire pâteux. On utilise entre 5% et 40% de charge fibreuse pour avoir une viscosité suffisante.

Après avoir fabriqué le précurseur de céramique sous forme gélifiée, on peut enduire directement le fil ou le câble en faisant circuler ce dernier dans un bain de ce précurseur de céramique sous forme gélifiée.

Dans une variante de cet exemple, après l'étape de fabrication du précurseur de céramique sous forme gélifiée, on trouve une étape de désensimage et d'imprégnation d'un ruban de fibres céramiques.

Ce ruban de fibres céramiques est tout d'abord désensimé. Ce ruban est par exemple en verre E, en verre C, en verre R, en verre S2, en silice, en alumine ou en mullite (qui est un silicate formant un constituant essentiel des céramiques).

Ce ruban peut être un ruban du commerce, par exemple en verre E de la société Bourgeois ou en verre S2 de la société Hiltex ou en céramique commercialisée sous la marque Nextel de la société 3M.

On peut aussi utiliser des fibres de silice commercialisée sous la marque Quartzel par la société Saint-Gobain, de préférence tissées avec une épaisseur de 60 µm par la société de Textile Bourguisanne.

Le désensimage peut être thermique (selon les prescriptions du fabricant du ruban), par exemple à 700°C pendant 1 minute ou 350°C pendant 20 heures.

En variante, on utilise un désensimage chimique avec un solvant adapté. Dans ce cas, le solvant ne sert qu'à dissoudre l'ensimage. Le choix du solvant et du temps de séjour en solution dépendent du type de ruban et des produits utilisés pour son ensimage. Le solvant ne doit donc dissoudre que des polymères et ne doit pas attaquer la fibre céramique.

Le ruban désensimé est ensuite imprégné avec le précurseur céramique sous forme gélifiée.

Ensuite, on dispose le ruban ainsi imprégné autour du fil ou du câble conducteur, ce ruban formant alors une gaine flexible, puis on met le conducteur en forme. A titre d'exemple, on bobine ce conducteur.

Ensuite, trois cas sont à distinguer.
(1) Si le conducteur est fait d'un précurseur de supraconducteur, à savoir le précurseur de Nb₃Sn ou de Nb₃Al (avant que ce matériau ait subi le traitement thermique qui lui donne ses propriétés supraconductrices), on réalise alors à la fois par montée en température :
   - le traitement thermique de réaction du Nb₃Sn ou du Nb₃Al,
   - l'élimination, par cuisson, du liant organique (et des résidus carbonés) sous une atmosphère neutre (par exemple une atmosphère d'argon ou d'azote), avec un apport d'oxygène au moment où la température est suffisante pour démarrer la carbonisation (oxydation) du liant (environ 350°C à 450°C selon le liant) de façon à injecter le minimum d'oxygène (correspondant à la carbonisation complète), ce qui permet d'obtenir la carbonisation complète du liant sans oxydation du conducteur car, entre 350°C et 450°C, la réaction d'oxydation est très préférentiellement active sur le liant, et
   - le frittage de la céramique.

   Pour ce traitement thermique global, dans le cas du Nb₃Sn, on fait croître la température depuis la température ambiante (environ 20°C) jusqu'à un palier de l'ordre de 600°C à 700°C (température de réaction du Nb₃Sn) pour une durée de 100 heures à 300 heures, durée qui est nécessaire à la transformation du précurseur de supraconducteur en supraconducteur Nb₃Sn.
   Dans le cas du conducteur avec le précurseur de Nb₃Al, on fait croître la température depuis la température ambiante jusqu'à un palier de l'ordre de 700°C à 800°C (température de réaction du Nb₃Al) pour une durée de quelques dizaines d'heures, durée qui est nécessaire à la transformation du précurseur de supraconducteur en supraconducteur Nb₃Al.
   Le liant et le précurseur de céramique réagissent aussi dans la gamme de température ci-dessus.
   Il faut surveiller la montée en température qui doit être très lente de façon à ce que le conducteur "n'explose" pas par passage de l'étain (ou l'aluminium) à l'état liquide, ce qui entraîne une expansion trop forte.
   Dans une variante, on modifie l'atmosphère de façon graduelle par introduction d'un mélange gazeux légèrement réducteur (par exemple un mélangé contenant moins de 5% d'hydrogène et plus de 95% d'azote car, s'il y avait plus d'hydrogène, le mélange serait explosif) au début du palier de traitement thermique de réaction du Nb₃Sn ou du Nb₃Al. Ce mélange remplace l'atmosphère d'argon ou d'azote et permet d'être sûr que le conducteur ne sera pas oxydé par d'éventuels résidus d'oxygène.
   Ce qui suit est également valable pour les cas (2) et (3).
   En ce qui concerne l'élimination du liant organique, on précise que la réaction doit avoir lieu à des températures compatibles avec le frittage de la céramique et avec le traitement de réaction du supraconducteur et doit aussi ne laisser aucun résidu de carbone (qui est un bon conducteur électrique).
   On utilise ici de l'oxygène avec lequel on est certain de tout éliminer par formation de gaz. De plus, cette réaction est très rapide dès que l'on dépasse 350°C. Le gaz engendré (CO ou CO₂) doit être évacué. C'est pourquoi le traitement thermique a lieu sous balayage de gaz.
   En outre, l'élimination du liant et le frittage se font au cours d'une même opération par enchaînement et imbrication de la phase d'élimination du liant et de la phase de frittage. Il s'agit d'une caractéristique essentielle de l'exemple considéré de l'invention.
   En effet, la gaine ne s'effrite pas grâce à cette imbrication, ou recouvrement partiel dans le temps, de l'étape d'élimination du liant et de l'étape de frittage. Sans imbrication, on risquerait d'obtenir une gaine pulvérulente très fragile et il ne faudrait pas perturber le conducteur mis en forme. Or, dans l'art antérieur, on sépare ces étapes et cela nécessite une imprégnation de résine.
   De plus, lorsqu'on veut former un enroulement très précis, ce qui est le cas des aimants supraconducteurs de types dipolaires ou quadripolaires, on le place de préférence dans un moule, par exemple en acier réfractaire, pour l'opération d'élimination du liant et de frittage et le balayage gazeux est effectué dans ce moule.
(2) Si le conducteur est fait d'un précurseur d'un supraconducteur à base d'oxyde de cuivre tel que :
   - YBa₂Cu₃O₇ de température critique 92 K,
   - Bi₂Sr₂CaCu₂O₈ de température critique 95 K,
   - Bi₂Sr₂Ca₂Cu₃O₁₀ de température critique 110 K,
      l'étape d'élimination complète du liant organique est réalisée par cuisson à l'air selon les paramètres de température, de durée et de montée en température qui dépendent du liant choisi et sont indiqués par le fournisseur de ce dernier.

   Ensuite, ont lieu à la fois le traitement thermique de réaction du supraconducteur et le frittage de la céramique. Les paramètres de ce traitement thermique, qui est effectué à l'air, sont une température de palier de l'ordre de 800°C à 900°C et un temps de palier de 10 minutes à 3 heures.
(3) Si le conducteur est fait d'un métal ou d'un composé métallique non supraconducteur, l'étape d'élimination thermique du liant organique a lieu en atmosphère neutre, avec introduction d'une quantité contrôlée d'oxygène, correspondant à la carbonisation complète du liant. En effet, à l'air le métal serait totalement oxydé, à moins que ce métal soit de l'or.

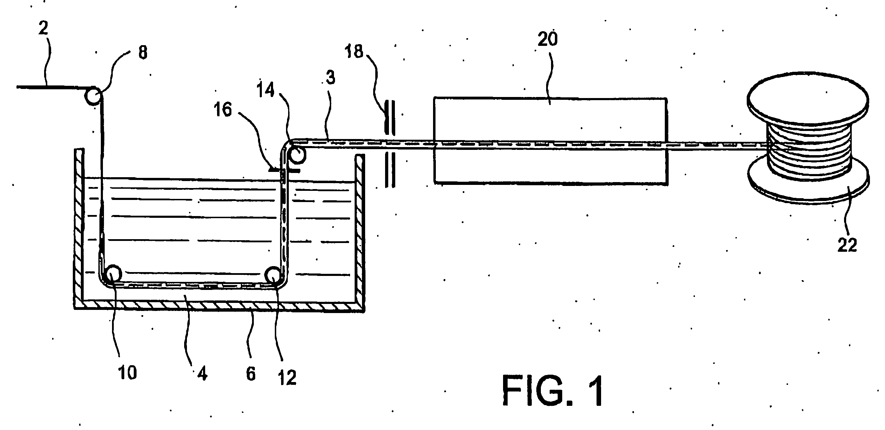

A titre purement indicatif et nullement limitatif, on donne un exemple de procédé conforme à l'invention en faisant référence à la figure 1. On voit sur cette figure un fil 2 sur lequel on forme un revêtement 3 de précurseur de céramique sous forme gélifiée en faisant passer ce fil 2 à travers ce précurseur de céramique sous forme gélifiée 4 contenu dans un récipient 6.

On voit également que le fil passe sur une succession de poulies 8, 10, 12 et 14 et passe aussi à travers une série de dispositifs de contrôle d'épaisseur 16 et 18 pour enlever les quantités en excès du revêtement 3 formé sur le fil. Le fil est alors séché en passant à travers un four de séchage 20 et ensuite bobiné sur une bobine appropriée 22.

On peut ensuite faire subir au fil ainsi bobiné les traitements thermiques mentionnés plus haut, qui permettent l'élimination du liant organique, la formation de la céramique et la formation du supraconducteur lorsque le fil 2 est supraconducteur.

Le fil 2 est ainsi pourvu d'une gaine électriquement isolante et mécaniquement structurante.

On donne maintenant, à titre d'exemple, une application de l'invention à la fabrication de bobinages d'électro-aimants supraconducteurs en Nb₃Sn, aptes à supporter le traitement thermique du conducteur et, en cours de fonctionnement, d'importants efforts mécaniques dus aux forces de Lorenz.

Plus précisément, on fabrique des électro-aimants quadripolaires comprenant chacun quatre bobinages identiques. Chacun de ceux-ci nécessite environ 75 m de câble supraconducteur. Ce dernier, de section légèrement trapézoïdale, est constitué de 36 brins à base de Nb₃Sn. Ces brins ont un diamètre de 0,825 mm et sont torsadés entre eux et répartis en deux couches.

Les dimensions de la section droite de ce câble sont : 1,362 mm pour le petit côté, 1,598 mm pour le grand côté et 15,1 mm pour la largeur.

Chacune des longueurs (75 m) de câble est enrubannée d'environ 400 m d'un ruban de 15 mm de largeur.

Ce ruban est constitué de fibres céramiques et imprégné d'une solution contenant de la boehmite et du mica en tant que charges minérales, une fritte de verre commercialisée sous la référence VN 821 par la société Cerdec, un dispersant et un liant respectivement commercialisés sous les références D-3005 et B-1000 par la société Rohm et Haas et de l'eau en tant que solvant.

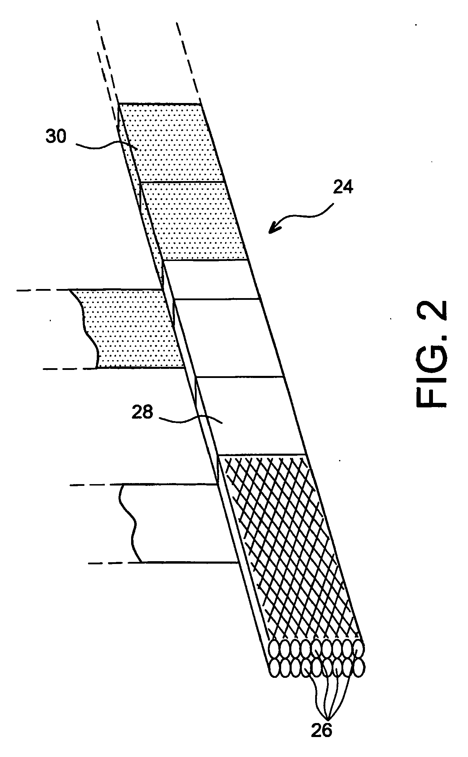

Ceci est schématiquement illustré par l'exemple de la figure 2 où l'on voit un câble 24 (avant traitement). Ce câble est un câble plat de type Rutherford, à deux couches de brins 26.

Le câble 24 est enrubanné : on voit un premier ruban 28 de fibres de verre, qui est imprégné de précurseur céramique et qui entoure le câble 24.

On voit en outre un deuxième ruban 30 de fibres de verre, qui est identique au premier et donc également imprégné de précurseur céramique.

Chacun de ces rubans 28 et 30 est enroulé autour du câble de façon à ce que le bord d'un tour de ruban se trouve contre le bord du tour adjacent, mais, en vue d'assurer la continuité de l'isolation électrique, le deuxième ruban 30, qui est enroulé par dessus le premier, est décalé d'un demi-pas par rapport à ce premier ruban 28.

D'autres sortes de frittes de verre et/ou de liants peuvent être utilisées.

Après avoir formé les bobinages, ces derniers sont soumis à un traitement thermique comprenant un chauffage à 6°C/heure jusqu'à 660°C. Ce chauffage est suivi d'un palier de 240 heures à 660°C et d'un refroidissement lent dans l'enceinte du four servant au traitement thermique.

Avant ce traitement thermique, on évacue l'air contenu dans cette enceinte et l'on remplit cette dernière d'un gaz neutre tel que l'argon. De plus, un balayage continu d'argon a lieu pendant le traitement thermique.

Pour atteindre l'état supraconducteur, chaque bobinage est refroidi à la température de l'hélium liquide (4,2 K à la pression atmosphérique) ou à celle de l'hélium superfluide (inférieure ou égale à 2,1 K à la pression atmosphérique).

Il convient de noter que, lors de l'excitation de chaque électro-aimant par un courant, des forces de Lorenz considérables sont créées dans les bobinages de celui-ci.

L'invention s'applique aussi à la fabrication de petits solénoïdes supraconducteurs compacts, dépourvus d'éléments métalliques structurants.

L'invention peut aussi être utilisée pour les bobinages de machines électriques tournantes supraconductrices.

L'invention peut en outre être utilisée pour les bobinages de machines électriques tournantes non supraconductrices, destinées à fonctionner à haute température (supérieure à 300°C).

L'invention peut également servir à la fabrication d'isolations électriques résistant à une forte chaleur, par exemple à celle d'une flamme, ou à des projections de liquides très chauds du fait de la faible porosité de l'isolant structurant.

## Revendications

1. Procédé de fabrication d'une gaine électriquement isolante et mécaniquement structurante sur un conducteur électrique (2), en particulier un conducteur en métal non supraconducteur ou un conducteur en précurseur de supraconducteur, ce procédé comprenant les étapes de :
- formation d'un précurseur de céramique (4) sous forme gélifiée,
- formation d'un revêtement (3) du conducteur avec ce précurseur de céramique sous forme gélifiée et donc sans sédimentation, et
- traitement thermique de ce revêtement (3), ce traitement thermique étant apte à former la céramique à partir du précurseur de céramique sous forme gélifiée,
**caractérisé en ce que** le précurseur de céramique est un liquide constitué par une solution comprenant de l'eau, un composant minéral, choisi parmi la boehmite et les argiles de la famille du kaolin, et un liant organique et l'on fait réagir le composant minéral avec un acide pour gélifier la solution et donc obtenir le précurseur de céramique (4) sous forme gélifiée, ce procédé comprenant en outre une étape d'élimination du liant organique après l'étape de formation du revêtement (3), cette étape d'élimination commençant avant l'étape de traitement thermique apte à former la céramique mais se terminant pendant cette étape de traitement thermique.

2. Procédé selon la revendication 1, dans lequel l'acide est choisi dans le groupe comprenant l'acide borique, l'acide citrique, l'acide chlorhydrique, l'acide nitrique et les acides carboxyliques, préférentiellement l'acide formique.

3. Procédé selon l'une quelconque des revendications 1 et 2, dans lequel la solution comprend en outre de la fritte de verre.

4. Procédé selon l'une quelconque des revendications 1 à 3, dans lequel la solution comprend en outre au moins un oxyde minéral supplémentaire.

5. Procédé selon l'une quelconque des revendications 1 à 4, dans lequel la solution comprend, en pourcentage massique, 35% à 45% d'eau, 8% à 30% du composant minéral, 1% à 10% de liant organique, 0% à 15% d'un ou d'une pluralité d'oxydes minéraux supplémentaires et un complément éventuel de fritte de verre.

6. Procédé selon la revendication 5, dans lequel le pourcentage massique du composant minéral va de 15% à 30% dans cette solution.

7. Procédé selon l'une quelconque des revendications 4 à 6, dans lequel chaque oxyde minéral supplémentaire est choisi dans le groupe comprenant l'alumine, la zircone, la silice et les argiles silico-alumineuses.

8. Procédé selon l'une quelconque des revendications 1 à 7, dans lequel on élimine le liant organique par réaction avec l'oxygène.

9. Procédé selon l'une quelconque des revendications 1 à 8, dans lequel le conducteur (2) est en précurseur du supraconducteur Nb₃Sn ou Nb₃Al et l'on effectue un traitement thermique global de ce conducteur pourvu du revêtement (3), ce traitement thermique global étant effectué dans une atmosphère neutre et apte à former le supraconducteur Nb₃Sn ou Nb₃Al, éliminer le liant organique et former la céramique.

10. Procédé selon l'une quelconque des revendications 1 à 8, dans lequel le conducteur (2) est en précurseur d'un supraconducteur à base d'oxyde de cuivre, en particulier YBa₂Cu₃O₇, Bi₂Sr₂CaCu₂O₂ ou Bi₂Sr₂Ca₂Cu₃O₁₀, et 1'on élimine le liant organique par chauffage clans l'air, du conducteur pourvu du revêtement (3) puis on effectue un traitement thermique global, dans l'air, du conducteur pourvu du revêtement, ce traitement thermique global étant apte à former le supraconducteur à base d'oxyde de cuivre et à former la céramique.

11. Procédé selon l'une quelconque des revendications 1 à 8, dans lequel le conducteur (2) est en métal non supraconducteur et l'on effectue un traitement thermique global de ce conducteur pourvu du revêtement (3), ce traitement thermique global étant effectué dans une atmosphère neutre et apte à éliminer le liant organique et à former la céramique.

12. Procédé selon l'une quelconque des revendications 1 à 11, dans lequel l'étape de formation du revêtement (3) comprend une étape de dépôt du précurseur de céramique sous forme gélifiée sur un tissu de fibres céramiques préalablement désensimé puis une étape de disposition du tissu pourvu du précurseur de céramique autour du conducteur.

13. Procédé selon la revendication 12, dans lequel les fibres céramiques sont faites d'un matériau choisi parmi le verre E, le verre C, le verre R, le verre S2, la silice, l'alumine et la mullite.

14. Procédé selon l'une quelconque des revendications 12 et 13, dans lequel le tissu de fibres céramiques est préalablement désensimé de façon thermique ou chimique.

15. Procédé selon l'une quelconque des revendications 1 à 14, dans lequel on met en forme, en particulier on bobine, le conducteur (2) pourvu du revêtement (3), avant l'étape de traitement thermique apte à former la céramique.

## Claims

1. Manufacturing process of an electrically insulating and mechanically structuring sheath on an electric conductor (2), in particular a conductor in non-superconducting metal or a conductor in superconducting precursor, this process comprising the stages of:
- formation of a ceramic precursor (4) in gel form,
- formation of a coating (3) of the conductor with this ceramic precursor in gel form and therefore without deposition, and
- heat treatment of this coating (3), this heat treatment being suitable for forming the ceramics from the ceramic precursor in gel form, **characterized in that** the ceramic precursor is a liquid made up of a solution comprising water, a mineral component, chosen from among boehmite and clays of the kaolin family, and an organic binding agent and the mineral component is made to react with an acid to gel the solution and therefore obtain the ceramic precursor (4) in gel form, said process also comprising a stage of eliminating the organic binder following the stage of forming coating (3), said elimination stage commencing with the heat treatment stage for forming the ceramic, but ends during said heat treatment stage.

2. Process according to claim 1, in which the acid is chosen from the group comprising boric acid, citric acid, hydrochloric acid, nitric acid and carboxylic acids, preferentially formic acid.

3. Process according to either of claims 1 and 2, in which the solution comprises furthermore glass frit.

4. Process according to any one of claims 1 to 3, in which the solution also comprises at least one supplementary mineral oxide.

5. Process according to any one of claims 1 to 4, in which the solution comprises, in weight percentage, 35% to 45% water, 8% to 30% mineral component, 1% to 10% of organic binding agent, 0% to 15% of one or a plurality of supplementary mineral oxides and a possible complement of glass frit.

6. Process according to claim 5, in which the weight percentage of the mineral component is between 15% and 30% in this solution.

7. Process according to any one of claims 4 to 6, in which each supplementary mineral oxide is chosen from the group comprising alumina, zirconia, silica and the alumino-silicate clays.

8. Process according to any one of claims 1 to 7, in which the organic binding agent is eliminated through reaction with oxygen.

9. Process according to any one of claims 1 to 8, in which the conductor (2) is in precursor of the superconductor Nb₃Sn or Nb₃Al and an overall heat treatment is carried out of this conductor provided with the coating (3), this overall heat treatment being carried out in a neutral atmosphere suitable for forming the superconductor Nb₃Sn or Nb₃Al, eliminate the organic binding agent and form the ceramics.

10. Process according to any one of claims 1 to 8, in which the conductor (2) is in precursor of a copper oxide based superconductor, in particular YBa₂Cu₃O₇, Bi₂Sr₂CaCu₂O₈ or Bi₂Sr₂Ca₂Cu₃O₁₀, and the organic binding agent is eliminated by heating in the air, of the conductor provided with the coating (3) then an overall heat treatment is carried out, in the air, of the conductor provided with the coating, this overall heat treatment being suitable for forming the copper oxide based superconductor and forming the ceramics.

11. Process according to any one of claims 1 to 8, in which the conductor (2) is in non-superconducting metal and an overall heat treatment of this conductor provided with the coating (3) is carried out, this overall heat treatment being carried out in a neutral atmosphere and suitable for eliminating the organic binding agent and forming the ceramics.

12. Process according to any ane of claims 1 to 11, in which the formation stage of the coating comprises a stage of deposit of the ceramic precursor in gel form on a material of ceramic fibres previously de-oiled then a stage of arrangement of the fabric provided with the ceramic precursor around the conductor.

13. Process according to claim 12, in which the ceramic fibres are made of a material chosen from E glass, C glass, R glass, S2 glass, silica, alumina and mullite.

14. Process according to either of claims 12 and 13, in which the fabric of ceramic fibres is previously de-oiled by heat or chemically.

15. Process according to any one of claims 1 to 14, in which the conductor (2) provided with the coating (3) is put into shape and particularly coiled, before the heat treatment stage suitable to form the ceramics.

## Patentansprüche

1. Vorfahren zur Herstellung einer elektrisch isolierenden und mechanisch strukturierenden Mantelung auf einem elektrischen Leiter (2), insbesondere einem Leiter aus nicht-supraleitendem metall oder einem Leiter aus Supraleitervorläufer, wobei dieses Vorfahren die folgenden Schritte umfasst:
- Bildung eines Keramikvorläufers (4) in gelierter Form,
- Bildung eines Überzugs (3) des Leiters mit diesem Keramikvorläufer in gelierter Form und folglich ohne Sedimentierung, und
- thermische Behandlung dieses Überzugs (3), wobei diese thermische Behandlung fähig ist, aus dem Keramikvorläufer in gelierter Form die Keramik zu bilden,
**dadurch gekennzeichnet, dass** der Keramikvorläufer eine Flüssigkeit ist, die durch eine Lösung gebildet wird, die Wasser, einen mineralischen Bestandteil ausgewählt unter Boehmit und den Tonen der Kaolingruppe, und ein organisches Bindemittel umfasst, und dass man den mineralischen Bestandteil mit einer Säure reagieren lässt, um die Lösung zu gelieren und folglich den Keramikvorläufer (4) in gelierter Form zu erhalten, wobei dieses Verfahren außerdem einen Schritt zur Eliminierung des organischen Bindemittels umfasst, nach dem Schritt zur Bildung des Überzugs (3), wobei dieser Eliminierungsschritt vor dem genannten thermischen Behandlungsschritt zur Bildung der Keramik beginnt aber während dieses thermischen Behandlungsschritts endet.

2. Verfahren nach Anspruch 1, bei dem die Säure aus der Gruppe gewählt wird, die Borsäure, Zitronensäure, Salzsäure, Salpetersäure und die Karbonsäuren, vorzugsweise die Ameisensäure, umfasst.

3. Verfahren nach einem der Ansprüche 1 und 2, bei dem die Lösung außerdem Glasfritte enthält.

4. Verfahren nach einem der Ansprüche 1 bis 3, bei dem die Lösung außerdem wenigstens ein zusätzliches mineralisches Oxid enthält.

5. Verfahren nach einem der Ansprüche 1 bis 4, bei dem die Lösung in Massenanteilen 35% bis 45% Wasser, 8% bis 30% mineralischen Bestandteil, 1% bis 10% organisches Bindemittel, 0% bis 15% von einem oder von mehreren zusätzlichen mineralischen Oxiden und eventuell einen Zusatz von Glasfritte enthält.

6. Verfahren nach Anspruch 5, bei dem der Massenanteil des mineralischen Bestandteils in dieser Lösung von 15% bis 30% geht.

7. Verfahren nach einem der Ansprüche 4 bis 6, bei dem jedes zusätzliche mineralische Oxid aus der Gruppe gewählt wird, die Aluminium, Zirkon, Siliciumdioxid bzw. Kieselerde und die Aluminiumsilikatone (argiles silico-alumineuses) umfasst.

8. Verfahren nach einem der Ansprüche 1 bis 7, bei dem man das organische Bindemittel mittels Reaktion mit Sauerstoff eliminiert.

9. Verfahren nach einem der Ansprüche 1 bis 8, bei dem der Leiter (2) aus Nb₃Sn- oder Nb₃Al-Supraleitervorläufer ist und man eine globale thermische Behandlung dieses mit dem Überzug (3) versehenen Leiters durchführt, wobei diese globale thermische Behandlung in einer Atmosphäre erfolgt, die neutral und fähig ist, den Nb₃Sn- oder Nb₃Al-Supraleiter zu bilden, das organische Bindemittel zu eliminieren und die Keramik zu bilden.

10. Verfahren nach einem der Ansprüche 1 bis 8, bei dem der Leiter (2) aus einem Vorläufer eines Supraleiters auf Kupferoxidbasis ist, insbesondere YBa₂Cu₃O₇, Bi₂Sr₂CaCu₂O₂ oder Bi₂Sr₂Ca₂Cu₃O₁₀, und man das organische Bindemittel durch Erwärmung des mit dem Überzug (3) versehenen Leiters in Luft eliminiert, wobei diese globale thermische Behandlung fähig ist, den Supraleiter auf Kupferoxidbasis zu bilden und die Keramik zu bilden.

11. Verfahren nach einem der Ansprüche 1 bis 8, bei dem der Leiter (2) aus nicht-supraleitendem Metall ist und man eine globale thermische Behandlung dieses mit dem Überzug (3) versehenen Leiters durchführt, wobei diese globale thermische Behandlung in einer Atmosphäre erfolgt, die neutral und fähig ist, das organische Bindemittel zu eliminieren und die Keramik zu bilden.

12. Verfahren nach einem der Ansprüche 1 bis 11, bei dem der Schritt zur Bildung des Überzugs (3) einen Schritt umfasst, um den Keramikvorläufer in gelierter Form auf ein vorher entsensimiertes (désensimé) Gewebe aus Keramikfasern aufzubringen, und dann einen Schritt umfasst, um das mit dem Keramikvorläufer versehene Gewebe um den Leiter herum anzubringen.

13. Verfahren nach Anspruch 12, bei dem die Keramikfasern aus einem Material sind, das ausgewählt wird unter E-Glas, C-Glas, R-Glas, S2-Glas, Siliciumdioxid, Aluminiumoxid und Mullit.

14. Verfahren nach einem der Ansprüche 12 und 13, bei dem das Keramikfasergewebe vorher auf thermische oder chemische Weise entsensimiert (désensimé) wird.

15. Verfahren nach einem der Ansprüche 1 bis 14, bei dem man den mit dem Überzug (3) versehenen Leiter (2) vor der die Keramik bildenden thermischen Behandlung formt und insbesondere aufspult.
